**Europäisches Patentamt**

**European Patent Office**

**Office européen des brevets**

(19)

(11) Veröffentlichungsnummer: **0 189 123 B1**

(12) # EUROPÄISCHE PATENTSCHRIFT

(45) Veröffentlichungstag der Patentschrift: **12.06.91**

(21) Anmeldenummer: **86100516.3**

(22) Anmeldetag: **16.01.86**

(51) Int. Cl.⁵: **H03H 9/64, H03H 3/08, H03H 9/02**

(54) **Mit akustischen Wellen arbeitendes Filter.**

(30) Priorität: **18.01.85 DE 3501567**

(43) Veröffentlichungstag der Anmeldung:
**30.07.86 Patentblatt 86/31**

(45) Bekanntmachung des Hinweises auf die
Patenterteilung:
**12.06.91 Patentblatt 91/24**

(84) Benannte Vertragsstaaten:
**AT DE FR GB IT NL**

(56) Entgegenhaltungen:
**FR-A- 2 392 545**
**GB-A- 2 086 167**

**PATENT ABSTRACTS OF JAPAN, Band 5, Nr.
145 (E-74)[817], 12. September 1981; & JP-
A-56 78 222 (HITACHI SEISAKUSHO K.K.)
27-06-1981**

**PATENT ABSTRACTS OF JAPAN, Band 8, Nr.
235 (E-275)[1672], 27. Oktober 1984; & JP-
A-59 117 310 (NIPPON DENKI K.K.) 06-07-1984**

(73) Patentinhaber: **Siemens Aktiengesellschaft
Wittelsbacherplatz 2
W-8000 München 2(DE)**

(72) Erfinder: **Bulst, Wolf-Eckhart, Dipl.-Phys.
Arnikastrasse 2
W-8011 Vaterstetten(DE)**
Erfinder: **Lindemann, Gertrud
Kolumbusstrasse 16
W-8000 München 90(DE)**
Erfinder: **Zibis, Peter, Dipl.-Ing.
Kafkastrasse 14
W-8000 München 83(DE)**

**Beschreibung**

Die vorliegende Erfindung bezieht sich auf eine Verbesserung für die Struktur eines Filters, das mit in einem Substrat oberflächennah laufenden akustischen Wellen arbeitet, wie im Oberbegriff des Patentanspruches 1 angegeben.

Ein die Erfindung betreffendes Filter kann nicht nur mit akustischen Oberflächenwellen (Rayleigh- und Bleustein-Wellen) im engen Sinne, sondern auch mit Lamb-Wellen, Love-Wellen, Surface-Skimming-Bulk-Wellen und dgl. betrieben werden, die in einem Substrat zumindest oberflächennah verlaufen. Welche Wellenart im Einzelfall erzeugt wird, hängt von dem Fachmann bekannten Maßnahmen der Dimensionierung der Wandler und ggf. auch von Anisotropie-Eigenschaften des Substrats ab.

Oberflächenwellen-Resonatorfilter im Sinne der Erfindung besitzen auf einem piezoelektrischen Substrat angeordnete Digitalstrukturen, zu denen als Wandler zu verwendende Interdigitalstrukturen und Reflektorstrukturen gehören. Interdigitalstrukturen bestehen aus benachbart abwechselnd elektrisch angeschlossene bzw. miteinander verbundenen Streifenelektroden.Die Digitalstruktur eines Reflektors besteht aus streifenförmigen Fingern, Fingerstücken, dots, oder dgl., die vorzugsweise auf der Substratoberfläche aufgebrachte Metallisierungsstreifen sind.

Anordnung und Bemessung der Finger, Streifen und dgl. einer jeweiligen der Strukturen richten sich nach den Vorgaben für das jeweilige Filter.Die Grundsätze für Bemessungenund Abmessungen der Digitalstrukturen sind bekannt. Es sei hierzu des weiteren verwiesen auf DE-A-29 09 705, US-A-4 325 037, DE-A-3 314 725.

Für Interdigitalstrukturen sind Sammelschienen (bus bars) vorgesehen, mit denen die Finger der jeweils einen Fingerstruktur miteinander verbunden sind. Die eine Fingerstruktur greift mit diesen Fingern kammartig in eine entsprechende zweite Fingerstruktur herein und bildet mit dieser zusammen die Interdigitalstruktur. An diese seitlich der Interdigitalstruktur angeordneten Sammelschienen schließt sich jeweils ein üblicherweise flächenmäßig relativ großes (Anschluß-) Pad an. Die für die als Wandler verwendete Interdigitalstruktur erforderlichen Zuleitungsdrähte sind an diesen Pads angeschlossen, die mit der jeweiligen Sammelschiene verbunden sind bzw. einen Anteil derselben bilden.

Anschlußpads verschiedenster bekannter Formen sind z.B. angegeben in JP-A-59-117310, JP-A-57-129510, EP-A-0054723, DE-A-3043156, US-A-3 716 809, Electronics Letters, Bd. 19 (1983), S. 1085.

Sammelschienen an Reflektorstrukturen sind angegeben in US-A-4 454 488, US-A-4 425 554, US-A-4 340 834.

Verschiedenartige Mischformen, bestehend aus Sammelschienen an Reflektorstrukturen und Pads, sind einzelnen der vorgenannten Druckschriften zu entnehmen.

Die Qualität und Leistungsfähigkeit eines derartigen Oberflächenwellenfilters hängt unter anderem ab von der exakten Ausbildung, Positionierung und präzisen scharfkantigen Begrenzung der streifenförmigen Finger der jeweiligen Digitalstruktur, sei es, daß es sich dabei um eine Interdigitalstruktur oder um eine Reflektorstruktur handelt.

Es ist eine Aufgabe der vorliegenden Erfindung, eine solche Struktur bzw. Strukturen für ein Oberflächenwellenfilter anzugeben, das diese Erfordernisse in optimaler Weise erfüllt.

Diese Aufgabe wird mit einer solchen Oberflächenwellen-Filterstruktur gelöst, bei der der jeweiligen Struktur einer oder mehrerer vorhandener Reflektorstrukturen seitlich Zusatzbelegungen der Substratoberfläche zugeordnet sind, wie dies aus dem Patentanspruch 1 näher hervorgeht. Weitere Ausgestaltungen und Weiterbildungen der Erfindung gehen aus den Unteransprüchen hervor. Verfahren zur Herstellung des Filters sind in den Ansprüchen 8 und 9 angegeben.

Der vorliegenden Erfindung liegt die Erkenntnis zugrunde, daß die oben angesprochenen Mängel einer Struktur bzw. der Strukturen eines Oberflächenwellenfilters auf Ursachen beruhen, die im Zusammenhang mit der fotolithografischen Herstellung und insbesondere im Zusammenhang mit dabei ausgeführter Projektionsbelichtung der auf der Substratoberfläche befindlichen fotoempfindlichen Schicht beruhen. Der noch zu ausreichend scharfen Konturen der herzustellenden streifenförmigen Finger bzw. Belegungen der Substratoberfläche beim fotolithografischen Verfahren zur Verfügung stehende Spielraum für die Belichtungsstärke des fotoempfindlichen Schichtmaterials ist relativ eng bemessen. Wie festgestellt wurde, genügt es dabei nicht, Belichtungsintensität und Belichtungsdauer passend aufeinander abgestimmt auszuwählen, um alle Anteile der herzustellenden Strukturen gleichermaßen zufriedenstellend zu belichten. Es ist nämlich in Betracht zu ziehen, daß in die Belichtung eines Flächenelements der Schicht Überstrahlungen in noch erheblichem Maße mit eingehen, die von (vergleichsweise zu den feinen Strukturen der streifenförmigen Fingerelemente) großflächigen Belichtungsstellen ausgehen. Solche großflächigen Belichtungsstellen sind die (für die Anbringung der elektrischen Anschlüsse eines Wandlers) erforderlichen Pads, die auf den beiden Seiten einer als Wandler dienenden Interdigitalstruktur üblicherweise angeordnet sind. Die Belichtung der dieser Interdigitalstruktur zugehörigen Fingerstreifen wird der von den Flächen des Pads ausgehenden Überstrahlung entsprechend derart verringert bemessen, daß im Endergebnis die erforderliche flächenspezifische Gesamtintensität (direkte Bestrahlung und Überstrahlungsanteil) für die Belichtungsstrahlung für das jeweilige streifenförmige Fingerelement bzw. für die jeweilige streifenförmige Belegung der Struktur erzielt ist. Bei der Erfindung ist vorgesehen, daß eine solche -an sich unerwünschte Überstrahlung aufgrund der oben erwähnten Ursache- auch für solche Digitalstrukturen bzw. Anordnungen von streifenförmigen Belegungen auftritt, zu denen (an sich) kein Pad vorzusehen ist. Bei einer Reflektorstruktur, bestehend aus elektrisch nicht angeschlossenen streifenförmigen Belegungen der Substratoberfläche, bedarf es keines Anschlußpads.

Bei der Erfindung ist nun vorgesehen, -wie dies aus der nachfolgenden Detailbeschreibung noch näher hervorgeht-Zusatzbelegungen auf beiden Seiten einer Reflektorstruktur anzuordnen , wobei eine solche Zusatzbelegung als eine in Längsrichtung des Filters sich erstreckende, die Reflektorstruktur seitlich begleitende Fortsetzung eines Pads der benachbarten Wandlerstruktur anzusprechen ist. Der Einfachheit halber wird man solche Zusatzbelegungen so bemessen, daß sie sich über die gesamte Reflektorstruktur erstrecken. Damit ist für die gesamte betreffende Reflektorstruktur von ihrem Anfang bis zu ihrem Ende durch die Flächen der begleitenden Zusatzbelegungen die gleiche Überstrahlung im Bereich der zu belichtenden streifenförmigen Belegungen erzielt, wie dies für eine mit Pads versehene Wandlerstruktur der Fall ist. Daraus ist zu ersehen, daß die Breite (b) einer solchen Zusatzbelegung möglichst gleichgroß wie die Breite des betreffenden benachbarten Pads bemessen sein sollte.

Bei einer Reflektorstruktur hat fehlende Präzision einer (einzelnen) streifenförmigen Belegung unterschiedlich große störende Wirkung, nämlich je nach dem, ob sich eine solche streifenförmige Belegung in der Reflektorstruktur in einem solchen Bereich derselben befindet, wo in hohem Maße Intensität der Welle reflektiert wird. Streifenförmige Belegungen des "abgewandten Endes" einer Reflektorstruktur, nämlich in einem Bereich, wo die in der Reflektorstruktur laufende Welle ohnehin nur noch erheblich geringere Intensität hat, stört eine unpräzise Ausführung einer streifenförmigen Belegung dieser Reflektorstruktur nur noch sehr viel weniger. Dementsprechend ist es bei der Erfindung nicht erforderlich, diese erfindungsgemäß vorgesehenen Zusatzbelegungen bis zum äußersten Ende E einer endständigen Reflektorstruktur reichen zu lassen. Im allgemeinen genügt es, wenn eine solche Zusatzbelegung sich wenigstens über die Hälfte der wirksamen Länge der betreffenden Reflektorstruktur erstreckt, und zwar von dem Anfang der Reflektorstruktur ausgehend, in den die zu reflektierende Welle einfällt.

Weitere Erläuterungen der Erfindung gehen aus der nachfolgenden anhand der Figuren gegebenen Beschreibung von Ausführungsbeispielen bzw. in diesen Ausführungsbeispielen enthaltener Varianten der Erfindung hervor.

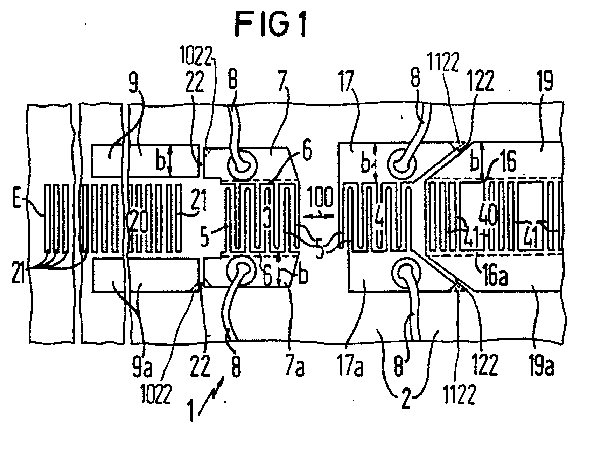

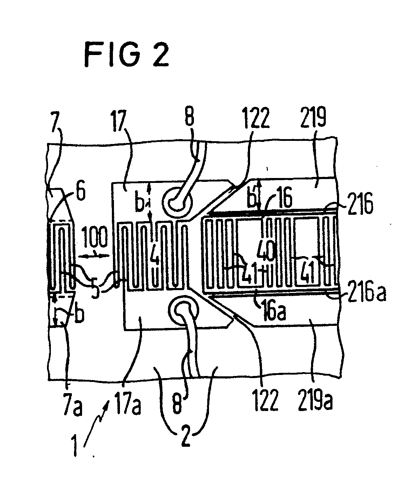

Die Figur 1 zeigt die Struktur eines Oberflächenwellenfilters, wobei diese Struktur alternative Ausgestaltungen umfaßt, die ebenfalls zur Erfindung gehören. Figur 2 zeigt eine weitere Variante.

Mit 1 ist ein die Erfindung betreffendes Oberflächenwellenfilter bezeichnet, dessen auf der Oberfläche eines nur teilweise dargestellten Substrats 2 befindliche Struktur -wiederum teilweise dargestellt ist. Mit 3 und mit 4 sind je ein Wandler, nämlich eine Interdigitalstruktur, bezeichnet,von denen der eine Wandler z.B. als Eingangswandler und der andere als Ausgangswandler dient. Mit 5 sind die streifenförmigen Belegungen, auch als Finger, Digitstreifen und dgl. benannt, bezeichnet. Wie für eine Interdigitalstruktur üblich, sind diese streifenförmigen Belegungen 5 abwechselnd elektrisch an eine jeweilige Sammelschiene 6 angeschlossen. Bei der Digitalstruktur 3 sind diese Sammelschienen 6 Anteile der Pads 7, 7a. Mit 8 sind die an die Pads 7, 7a angeschlossenen Zuleitungen des betreffenden Wandlers bezeichnet. Mit 9, 9a sind die erfindungsgemäß vorgesehenen flächenmäßigen Fortsetzungen der Pads 7, 7a bezeichnet. Dabei ist die mit 9 bezeichnete Fläche die Fortsetzung des Pads 7 und die mit 9a bezeichnete Fläche die Fortsetzung des Pads 7a. Bereits aus dieser Darstellung der Figur ist ersichtlich, daß bei der lithografischen Herstellung der Digitalstruktur 3 für die streifenförmigen Belegungen 5 dieser Digitalstruktur 3 auftretende Überstrahlung praktisch gleichermaßen in entsprechender Weise auch für die streifenförmigen Belegungen 21 der dargestellten Reflektorstruktur 20 auftritt. Für die streifenförmigen Belegungen 21 geht jedoch diese Überstrahlung von den Flächen der Fortsetzungen 9 und 9a aus. Dementsprechend sind die spezifischen Flächenanteile dieser Fortsetzungen 9 und 9a wenigstens angenähert gleich groß den spezifischen Flächenanteilen der Pads 7 und 7a bemessen. Der Begriff "spezifisch" bezieht sich dabei auf die mit dem Pfeil 100 bezeichnete Längsrichtung bzw. Laufrichtung des Filters 1 .

Die streifenförmigen Belegungen 21 der als Resonator wirksamen Digitalstruktur 20 besitzen keine Sammelschienen, wie dies zu einer Reflektorstruktur auch nicht erforderlich ist.

Es ist aus elektrischen Gründen zweckmäßig, die flächenmäßigen Fortsetzungen 9 bzw. 9a elektrisch gegenüber dem benachbarten Pad 7 bzw. 7a zu trennen. In einfacher Weise ist dies mit Hilfe der dargestellten Unterbrechungen 22 zu erreichen, die zwischen dem Pad 7 und der Fortsetzung 9 bzw. zwischen dem Pad 7a und der Fortsetzung 9a befindliche schmale Streifen ohne Metallbelegung sind. Im lithografischen Herstellungsprozeß entsprechen diese Streifen 22 Stellen, die keine Belichtung erfahren. Der Ausfall einer von diesen Streifen 22 (bei Weglassen derartiger Streifen 22) ansonsten ausgehender Überstrahlung, ist im Rahmen der Erfindung insbesondere dann kein Nachteil, wenn diese Streifen 22 in einen solchen Bereich des Filters 1 (wie links in der Figur dargestellt) gelegt sind, in dem in aller nächster Nähe ohnehin keine streifenförmige Belegung zu erzeugen bzw. vorgesehen ist.

Wie weiter aus der Figur ersichtlich, reichen die erfindungsgemäß vorgesehenen flächenmäßigen Fortsetzungen 9 und 9a nicht bis zum äußersten Ende der dargestellten Reflektorstruktur 20. Wie dies bereits oben angedeutet wurde, haben die streifenförmigen Belegungen, die an dem dem Einfallsort der Welle gegenüberliegenden Ende der Reflektorstruktur 20 vorhanden sind, ohnehin nur noch vergleichsweise sehr viel geringeren Einfluß auf die Gesamtreflexion der Struktur 20. Daher sind von der erreichbaren Präzision auftretende Abweichungen in der Positionierung und Kantenschärfe solcher am Ende der Reflektorstruktur 20 vorhandener streifenförmiger Belegungen 21 von bereits vernachlässigbarem Einfluß. Insbesondere der Einfachheit halber wird man in der Praxis jedoch diese Fortsetzungen 9, 9a bis zum äußersten Ende der jeweiligen Reflektorstruktur, die diese Fortsetzungen 9, 9a begleiten, gehen lassen.

Wie dies auch aus der Figur hervorgeht, sind im allgemeinen die Digitalstrukturen eines wie dargestellten Resonatorfilters wenigstens im wesentlichen symmetrisch angeordnet. Im Falle der vorliegenden Figur kann die (in der Figur) rechte Hälfte des Filters 1 identisch der bereits beschriebenen linken Hälfte ausgeführt sein. Die nachfolgende Beschreibung bezieht sich jedoch auf eine im Rahmen der Erfindung liegende Variation, wobei diese Variation der rechten Hälfte wiederum identisch auch die linke Hälfte des Filters ausfüllen kann. Es sei aber ausdrücklich darauf hingewiesen, daß Symmetrie keine Notwendigkeit, und zwar auch nicht für ein erfindungsgemäßes Filter, ist.

Mit 17 und 17a sind die Pads der Interdigitalstruktur 4 bezeichnet. Im übrigen gilt für diese Struktur das zur Figur 3 oben ausgeführte zumindest sinngemäß.

Mit 40 ist eine wiederum vorgesehene Resonatorstruktur bezeichnet, die die streifenförmigen Belegungen 41 hat. Mit 19 und 19a sind erfindungsgemäß vorgesehene, flächenmäßige Fortsetzungen der Pads 17 bzw. 17a bezeichnet. Von den Fortsetzungen 9 und 9a unterscheiden sich diese Fortsetzungen 19, 19a darin, daß sie bis an die streifenförmigen Belegungen (Finger, Digitstreifen) 41 der Reflektorstruktur 40 heranreichen und mit dieser sogar elektrischen Kontakt haben können. Von in Einzelfällen bereits bekanntermaßen verwendeten Sammelschienen 16, 16a einer Reflektorstruktur unterscheiden sich die erfindungsgemäß vorgesehenen Fortsetzungen 19 und 19a vor allem in ihrer ganz wesentlich größeren Breite d, nämlich in ihrer den Pads 17, 17a entsprechend im wesentlichen gleich großen Breite b. Außerdem ist bei dieser dargestellten Ausführungsform der Erfindung die elektrische Unterbrechung 122 erforderlich, damit Kurzschluß zwischen dem Wandler 4 und der Reflektorstruktur 40 ausgeschlossen ist.

Die den Unterbrechungen 22 an sich entsprechenden Unterbrechungen 122 sind, wie dargestellt, schrägliegend angeordnet. Diese schräge Anordnung ist insbesondere dann von im Rahmen der Erfindung liegendem Vorteil, wenn zwischen der Wandlerstruktur 4 und der anschließenden Reflektorstruktur 40 kein oder ein nur vergleichsweise geringer Abstand vorhanden ist oder diese Unterbrechung (-en) 122 bereits seitlich neben der Reflektorstruktur positioniert ist. Diese, wie aus der Figur ersichtliche, schräge Anordnung der Unterbrechungen 122 hat, und zwar aufgrund dieser schrägen Anordnung, keinen merklich störenden Einfluß auf die Gleichmäßigkeit der Überstrahlung, nämlich sowohl für die streifenförmigen Belegungen 5 der Digitalstruktur 4 als auch für die streifenförmigen Belegungen 41 der Reflektorstruktur 40.

Nachfolgend werden Bemessungen angegeben, die für ein Filter nach der Erfindung typisch sind.

Eine Wandlerstruktur 3, 4 hat z.B. zehn bis 400, vorzugsweise 50 bis 150, streifenförmige Belegungen in interdigitaler Anordnung.

Eine Reflektorstruktur 20, 40 hat z.B. 200 bis 1000, vorzugsweise 400 bis 700, streifenförmige Belegungen.

Die jeweilige Anzahl streifenförmiger Belegungen einer Wandler- oder Reflektorstruktur richtet sich nach der jeweils vorgegebenen Bandbreite.

Breite und (Mitten-)abstand der streifenförmigen Belegungen voneinander ist durch die vorgegebene Frequenz bzw. Wellenlänge der akustischen Welle und die Wellenfortpflanzungsgeschwindigkeit im Substratkörper gegeben. Übliche Werte für die Streifenbreite sind 0,5 bis 5 $\mu$m und für den Mittenabstand 1 bis 10 $\mu$m.

Die Länge der einzelnen streifenförmigen Belegungen wird üblicherweise zwischen 20 und 200 Wellenlängen bemessen.

Die Breite b eines Pads 7, 7a, 17, 17a und damit auch der erfindungsgemäß vorgesehenen Fortsetzungen 9, 9a; 19, 19a liegt zwischen 10 und 300 $\mu$m. Als Vergleich dazu wird die übliche Breite einer Sammelschiene 6 angegeben, die üblicherweise zwischen 1 und 10 μm liegt, d.h., daß eine Sammelschiene äußerst schmal gegenüber der Breitanabmessung b eines Pads ist, so daß ohne weiteres erkennbar ist, was ein Pad und was lediglich eine Sammelschiene ist.

Die voranstehende Beschreibung der Erfindung berücksichtigt die Herstellung der Digitalstrukturen nach dem Prinzip der Abhebetechnik (lift-off-Technik). Bei dieser Technik wird (positiv-) fotoempfindlicher Lack verwendet. Auf der Substratoberfläche wird zunächst eine ganzflächige Beschichtung mit derartigem Fotolack vorgenommen. Es erfolgt dann die den gewünschten Strukturen entsprechende Belichtung, und zwar werden diejenigen Flächenteile der auf der Substratoberfläche befindlichen Schicht belichtet, die später streifenförmige Belegungen 5, 21, 41, Pads 7, 7a; 17, 17a, Sammelschienen und die erfindungsgemäß vorgesehenen Zusatzbelegungen 9, 9a; 19, 19a sind. Nach dem Entwickeln wird der belichtete Anteil des Fotolacks abgelöst und die ganze Oberfläche (freigelegte Flächenanteile der Substratoberfläche und noch verbliebener Fotolack) mit einer Metallschicht überzogen (bedampft). Schließlich werden die noch zurückgebliebenen Flächenanteile des Fotolacks abgelöst, dabei von der Metallschicht die Anteile abgehoben, die sich auf Fotolack befinden, und es bleiben die gewünschten Strukturen als metallische Belegungen auf der Substratoberfläche zurück.

Sozusagen der entgegengesetzte Prozeß ist die (mit dem gleichen Endergebnis erfolgende) Herstellung der Strukturen nach einem Prinzip der Ätztechnik. Dabei wird zunächst die Substratoberfläche mit einer Metallschicht überzogen. Diese Metallschicht wird mit der Fotolackschicht überzogen und es erfolgt nunmehr die Belichtung, hier aber derjenigen Flächenanteile, die beim fertigen Filter frei von Metallisierungen der Substratoberfläche sind. Nach dem Entwickeln des belichteten Fotolacks erfolgt das Ablösen, wobei die darunter befindliche, auf der Substratoberfläche vorhandene Metallisierungsschicht in den Flächenanteilen freigelegt wird, die beim fertigen Filter frei von Metallisierung der Substratoberfläche sein müssen. Durch nachfolgendes Ätzen werden diese freigelegten Anteile der Metallisierungsschicht von der Substratoberfläche entfernt und es bleiben die während des Ätzens durch die noch verbliebenen Flächenanteile der Fotolackschicht geschützten Anteile der ursprünglichen Metallisierung der Substratoberfläche als gewünschte Strukturen des Filters zurück.

Die Abhebetechnik und die Ätztechnik unterscheiden sich darin, daß die jeweils komplementären Flächenanteile zu belichten sind. Bei der Abhebetechnik geht die Überstrahlung von den Pads und von den erfindungsgemäß vorgesehenen Zusatzbelegungen aus. Bei der Ätztechnik erfolgt, und zwar wenn die erfindungsgemäße Maßnahme der Zusatzbelegungen nicht gemacht worden ist, Überstrahlung im Bereich einer Reflektorstruktur, die keine Pads besitzt. Würde beim Verfahren der Ätztechnik die Belichtung (einschließlich der Überstrahlung) auf das für die Reflektorstruktur 20, 40, und zwar ohne daß Zusatzbelegungen 9, 9a; 19, 19a vorgesehen sind, geeignete Maß abgestimmt werden, würde Unterbelichtung im Bereich der Interdigitalstrukturen 3, 4 vorliegen, weil dort bei dem der Ätztechnik entsprechenden Belichtungsschema wegen der vorhandenen Pads keine Überstrahlung auftritt. Würde dagegen diese Belichtung auf das für die Interdigitalstrukturen erfoderliche Maß abgestimmt werden, läge dann für die jeweilige Resonatorstruktur, nämlich aufgrund der Überstrahlung, Überbelichtung vor. Werden auch beim Prinzip der Ätztechnik erfindungsgemäß Zusatzbelegungen 9, 9a; 19, 19a entlang den Seiten der jeweiligen Resonatorstruktur 20, 40 vorgesehen, ist auch bei Ätztechnik, und zwar ebenso wie bei Anwendung der vorausgehend allgemein und speziell beschriebenen Anwendung der Erfindung bei Abhebetechnik, das gleiche aufgabengemäße Ziel egalisierter Belichtung erreicht.

Figur 2 zeigt eine weitere Variante einer Ausführung der Erfindung. Mit Bezugszeichen der Figur 1 versehene Einzelheiten der Figur 2 sind übereinstimmend. Es ist jeweils ein elektrische Unterbrechung bewirkender Spalt 216, 216a zwischen jeweils der Sammelschiene 16, 16a und der erfindungsgemäß vorgesehenen Zusatzbelegung 219, 219a vorhanden. Die Breite b' der Zusatzbelegung 219, 219a ist vorzugsweise so bemessen, daß sich zusammen mit der Breite der jeweiligen Sammelschiene 16, 16a die Breite b (der Zusatzbelegung 19 bzw. 19a) ergibt; denn der Spalt 216, 216a ist relativ schmal bemessen. Die Variante nach Figur 2 ist hinsichtlich der sich ergebenden kapazitiven Verhältnisse vorteilhaft.

Die elektrischen Unterbrechungen 22, 122 sind vorzugsweise sogar so schmal bemessen (damit wird eine durch diese Unterbrechungen mögliche Verminderung des mit der Erfindung angestrebten und erzielten Effekts optimal gering gehalten), daß diese Unterbrechungen im Mikroskop praktisch nicht mehr deutlich erkennbar sind. Um dennoch sicherzustellen, daß das Anbonden der Zuleitungen 8 tatsächlich an den Pads 7, 7a, 17, 17a erfolgt, ist vorteilhafterweise ergänzend je eine Zusatzaussparung vorgesehen, wie sie in Figur 1 als Beispiel zu den Unterbrechungen 22, 122 dargestellt und mit 1022, 1122 bezeichnet sind. Diese Zusatzaussparungen 1022, 1122 sind vorzugsweise nur bis maximal etwa b/4 tief bemessen und erstrecken sich vom äußeren Rand in das jeweilige Pad 17, 17a und/oder 7, 7a bzw. in die Zusatzbelegung 9, 9a. Diese Zusatzaussparungen sind im Mikroskop

deutlich zu erkennen.

## Ansprüche

1. Mit akustischen Wellen arbeitendes elektrisches Filter mit einer Anzahl aus Belegungen der Oberfläche des Substrats (2) des Filters bestehenden Digitalstrukturen, von denen wenigstens eine Struktur eine Wandlerstruktur (3, 4) mit Sammelschienen (6) und Pads (7, 7a, 17, 17a) ist, wobei die Pads im Verhältnis zu einer ohne jeweiliges Pad vorzusehenden Sammelshienen großflächig sind, und wenigstens eine andere Struktur eine benachbart angeordnete Reflektorstruktur (20,40), ggf. mit Sammelschienen (6), ist **gekennzeichnet** dadurch,
   - daß auf beiden Seiten der vorhandenen Reflektorstruktur (-en) (20, 40) Zusatzbelegungen (9,9a;19,19a, 219, 219a) vorgesehen sind,
   - die jeweils einer in Längsrichtung (100) des Filters sich erstreckenden flächenmäßigen Fortsetzung der Pads (7,7a;17,17a) der der betreffenden Reflektorstruktur (20, 40) jeweils benachbarten Wandlerstruktur (3, 4) entsprechen,
   - wobei diese Fortsetzungen sich seitliche Wenigstens über den für die Reflexionswirkung der betreffenden Reflektorstruktur (20, 40) wesentlichen Anteil der betreffenden ganzen Reflektorstruktur (20, 40) erstrecken und
   - daß diese als Fortsetzungen ausgebildeten Zusatzbelegungen (9, 9a; 19, 19a; 219, 219a) von dem jeweiligen benachbarten Pad (7, 7a; 17, 17a) durch jeweils eine Unterbrechung (22; 122) elektrisch getrennt sind.

2. Filter nach Anspruch 1, **gekennzeichnet** dadurch,
   daß eine solche Unterbrechung (122), bezogen auf die Längsrichtung (100) des Filters, schrägliegend ausgebildet ist.

3. Filter nach Anspruch 1 oder 2, **gekennzeichnet** dadurch,
   daß die jeweilige Zusatzbelegung (19, 19a) mit einer vorhandenen Sammelschiene (16) der betreffenden Reflektorstruktur (40) verbunden ist.

4. Filter nach Anspruch 1 oder 2, **gekennzeichnet** dadurch, daß die jeweilige Zusatzbelegung (219, 219a) von einer benachbart vorhandenen Sammelschiene (16, 16a) der betreffenden Reflektorstruktur (40) elektrisch getrennt ist.

5. Filter nach einem der Ansprüche 1 bis 4, **gekennzeichnet** dadurch, daß Zusatzaussparungen (1022; 1122) im Bereich von Unterbrechungen (22 und/oder 122) vorgesehen sind.

6. Filter nach einem der Ansprüche 1 bis 5, **gekennzeichnet** dadurch, daß sich die Zusatzbelegungen (9,9a;19,19a; 219, 219a) über die Gesamtlänge der betreffenden Reflektorstruktur (40) erstrecken.

7. Filter nach einem der Ansprüche 1 bis 6, **gekennzeichnet** dadurch,
   daß die Zusatzbelegungen (9,9a;19,19a, 219, 219a) im wesentlichen jeweils flächenmäßig unmittelbare Verlängerungen des betreffenden benachbarten Pads (7,7a;17,17a) sind.

8. Verfahren zur Herstellung eines mit akustischen Wellen arbeitenden elektrischen Filters nach wenigstens einem der Ansprüche 1 bis 7, wobei die vorhandenen Digitalstrukturen mit Hilfe eines fotolithografischen Verfahrensmit Abhebetechnik hergestellt werden, **gekennzeichnet** dadurch,
   daß auf beiden Seiten der vorhandenen Reflektorstruktur(-en) (20, 40) flächenmäßige Belichtungen für Zusatzbelegungen (9,9a;19, 19a, 219, 219a) durchgeführt werden, wobei diese Zusatzbelegungen so bemessen und positioniert werden, daß diese flächenmäßigen Belichtungen jeweils einer Fortsetzung des benachbarten Pads (7,7a;17,17a) einer jeweils benachbarten Wandlerstruktur (3,4) entsprechen.

9. Verfahren zur Herstellung eines mit akustischen Wellen arbeitenden elektrischen Filters nach wenigstens einem der Ansprüche 1 bis 7, wobei die vorhandenen Digitalstrukturen mit Hilfe eines fotolithografischen Verfahrens mit Ätztechnik hergestellt werden, **gekennzeichnet** dadurch,
   daß auf beiden Seiten der vorhandenen Reflektorstruktur (-en) (20, 40) zusätzlich nicht zu belichtende Flächen für Zusatzbelegungen (9, 9a; 19, 19a, 219, 219a) vorzusehen sind, wobei die Flächen für diese Zusatzbelegungen so bemessen und positioniert werden, daß diese nicht belichteten Flächen jeweils einer Fortsetzung (9, 9a; 19, 19a) des benachbarten Pads (7, 7a; 17, 17a) einer jeweils benachbarten Wandlerstruktur (3,;4) entsprechen.

## Claims

1. Electric acoustic-wave filter comprising a number of digital structures consisting of coatings of the surface of the substrate (2) of the filter, of which at least one structure is a transducer structure (3, 4) having busbars (6) and pads (7, 7a, 17, 17a), the pads having a large area in relation to a busbar to be provided without any pad, and at least one other structure is a reflector structure (20, 40) arranged adjacently with busbars (6) as the case may be, characterised in that
   - auxiliary coatings (9, 9a; 19, 19a;, 219, 219a) are provided on both sides of the existing reflector structure(s) (20, 40),
   - which correspond in each case to an area-wise continuation, extending in the longitudinal direction (100) of the filter, of the pads (7, 7a; 17, 17a) of the transducer structure (3, 4) respectively adjacent to the relevant reflector structure (20, 40),
   - said continuations extending laterally at least over the portion of the relevant entire reflector structure (20, 40) that is essential for the reflecting effect of the relevant reflector structure (20, 40) and in that
   - said auxiliary coatings (9, 9a; 19, 19a; 219, 219a) constructed as continuations are electrically separated from the respective adjacent pad (7, 7a; 17, 17a) by an interruption (22; 122), in each case.

2. Filter according to Claim 1, characterised in that said interruption (122) is constructed obliquely relative to the longitudinal direction (100) of the filter.

3. Filter according to Claim 1 or 2, characterised in that the respective auxiliary coating (19, 19a) is connected to an existing busbar (16) of the relevant reflector structure (40).

4. Filter according to Claim 1 or 2, characterised in that the respective auxiliary coating (219, 219a) is electrically separated from an adjacent existing busbar (16, 16a) of the relevant reflector structure (40).

5. Filter according to one of Claims 1 to 4, characterised in that auxiliary cutouts (1022; 1122) are provided in the region of interruptions (22 and /or 122).

6. Filter according to one of Claims 1 to 5, characterised in that the auxiliary coatings (9, 9a; 19, 19a; 219, 219a) extend over the entire length of the relevant reflector structure (40).

7. Filter according to one of Claims 1 to 6, characterised in that the auxiliary coatings (9, 9a; 19, 19a; 219, 219a) are in each case essentially direct area-wise extensions of the relevant adjacent pad (7, 7a; 17, 17a).

8. Method of manufacturing an electric acoustic-wave filter according to at least one of Claims 1 to 7, the existing digital structures being manufactured with the aid of a photolithographic method using the lift-off technique, characterised in that area-wise exposures are carried out on both sides of the existing reflector structure(s) (20, 40) for auxiliary coatings (9, 9a; 19, 19a; 219, 219a), said auxiliary coatings being dimensioned and positioned such that said area-wise exposures correspond in each case to a continuation of the adjacent pad (7, 7a; 17, 17a) of a respectively adjacent transducer structure (3, 4).

9. Method of manufacturing an electric acoustic-wave filter according to at least one of Claims 1 to 7, the existing digital structures being manufactured with the aid of a photolithographic method using the etching technique, characterised in that areas which are not to be exposed are additionally to be provided on both sides of the existing reflector structure(s) (20, 40) for auxiliary coatings (9, 9a; 19, 19a; 219, 219a), the areas for these auxiliary coatings being dimensioned and positioned such that said non-exposed areas correspond in each case to a continuation (9, 9a; 19, 19a) of the adjacent pad (7, 7a; 17, 17a) of a respectively adjacent transducer structure (3, 4).

## Revendications

1. Filtre électrique travaillant avec des ondes acoustiques et comportant un certain nombre de structures numériques, qui sont constituées par des revêtements de la surface du substrat (2) du filtre et dont l'une au moins est une structure de transducteur (3,4) possédant des barres omnibus (6) et des plots (7,7a,17,17a), qui possèdent une surface étendue par rapport à une barre omnibus devant être prévue sans plot, et au moins une autre structure qui est une structure réfléchissante (20,40) disposée au voisinage et comportant éventuellement des barres omnibus (6),
caractérisé par le fait
   - quedes deux côtés de la ou des structures réfléchissantes existantes (20,40) sont prévus des revêtements supplémentaires (9,9a;19;19a;219,219a),

- qui correspondent chacune à un prolongement, qui possède une certaine étendue et s'étend dans la direction longitudinale (100) du filtre, des plots (7,7a;17,17a) de la structure de transducteur (3,4) respectivement voisine de la structure réfléchissante considérée (20,40),

- ces prolongements s'étendant latéralement au moins sur la partie, qui est importante pour l'action de réflexion de la structure réfléchissante considérée (20,40), de l'ensemble de cette structure, et

- que ces revêtements supplémentaires (9,9a;19,19a;219,219a), réalisés sous la forme de prolongements, sont séparés électriquement du plot respectif voisin (7,7a;17, 17a), par des interruptions respectives (22; 122).

2. Filtre selon la revendication 1, caractérisé par le fait qu'une telle interruption (122) est disposée obliquement par rapport à la direction longitudinale (100) du filtre.

3. Filtre suivant la revendication 1 ou 2, caractérisé par le fait que le revêtement supplémentaire respectif (19,19a) est raccordé à une barre omnibus existante (16) de la structure réfléchissante considérée (40).

4. Filtre suivant la revendication 1 ou 2, caractérisé par le fait que le revêtement supplémentaire respectif (219,219a) est séparé électriquement d'une barre omnibus (16,16a), qui est présente au voisinage, de la structure réfléchissante considérée (40).

5. Filtre suivant l'une des revendications 1 à 4, caractérisé par le fait que des évidements supplémentaires (1022; 1122) sont prévus au voisinage d'interruptions (22 et/ou 122).

6. Filtre suivant l'une des revendications 1 à 5, caractérisé par le fait que les revêtements supplémentaires (9,9a; 19,19a; 219,219a) s'étendent sur toute la longueur de la structure réfléchissante considérée (40).

7. Filtre suivant l'une des revendications 1 à 6, caractérisé par le fait que les revêtements supplémentaires (9,9a; 19,19a; 219,219a) sont pour l'essentiel des prolongements respectifs directs, possédant une certaine étendue, des plots voisins considérés (7,7a;17,17a).

8. Procédé pour fabriquer un filtre électrique fonctionnant avec des ondes acoustiques, suivant au moins l'une des revendications 1 à 7, et selon lequel on fabrique les structures numériques présentes à l'aide d'un procédé photolithographique avec une technique de décollement, caractérisé par le fait qu'on réalise, des deux côtés de la ou des structures réfléchissantes existantes (20,40), des expositions sur une certaine surface pour des revêtements supplémentaires (9,9a; 19,19a; 219,219a), ces revêtements supplémentaires étant dimensionnés et positionnés de telle sorte que ces expositions réalisées sur une certaine surface correspondent respectivement à un prolongement du plot voisin (7,7a; 17,17a) d'une structure de transducteur (3,4) respectivement voisine.

9. Procédé pour fabriquer un filtre électrique fonctionnant avec des ondes acoustiques, suivant au moins l'une des revendications 1 à 7, et selon lequel on fabrique les structures numériques présentes à l'aide d'un procédé photolithographique avec une technique de corrosion, caractérisé par le fait qu'il faut en outre prévoir, des deux côtés de la ou des structures réfléchissantes existantes (20, 40), des surfaces ne devant pas être exposées pour des revêtements supplémentaires (9,9a; 19,19a; 219,219a), les surfaces pour ces revêtements supplémentaires étant dimensionnées et positionnées de telle sorte que ces surfaces non exposées correspondent respectivement à un prolongement (9,9a; 19,19a) du plot voisin (7,7a; 17,17a) d'une structure de transducteur (3,4) respectivement voisine.

# FIG 1

# FIG 2